# EUROPEAN PATENT APPLICATION

(11) **EP 2 711 801 A2**
(43) Date of publication of application: **26.03.2014**
(21) Application number: 13182671.1
(22) Date of filing: 02.09.2013
(51) Int. Cl.: G06F 1/20, G06F 1/26, G06F 11/30

(54) **Power-supply controlling system and method**

(30) Priority: 07.09.2012 JP 2012196804
(71) Applicant: FUJITSU LIMITED, Kawasaki-shi, Kanagawa 211-8588 (JP)
(72) Inventor: WAJIMA, Eiji, Kawasaki-shi, Kanagawa 211-8588 (JP)
(74) Representative: Ward, James Norman

(57) **Abstract**

A power-supply controlling system includes an integrated circuit that outputs a first instruction signal, which instructs an electricity-supply unit to supply electricity to a device that releases heat, a detecting unit that detects an operating status of a cooling unit that cools the device, a state signal generating unit that generates a state signal in accordance with the detected operating status, the state signal indicating whether or not the cooling unit is being driven, and an output unit that generates a second instruction signal by using the first instruction signal and the state signal, and outputs the second instruction signal to the electricity-supply unit, the second instruction signal giving an instruction to supply electricity to the device.

## Description

### FIELD

The embodiment discussed herein is related to control of power supply to a heat-releasing body.

### BACKGROUND

Methods for cooling a heat-releasing body such as a CPU (Central Processing Unit) include a cooling method that relies on a liquid refrigerant. Examples of such a cooling method include a fluid-temperature controlling system wherein a fluid temperature is measured during starting of the system, the measured temperature is compared with a preset temperature, the startup of a refrigerating machine that cools the fluid is controlled according to the result of the comparing, and operations of a heat-releasing body are started after the fluid temperature reaches the preset temperature.

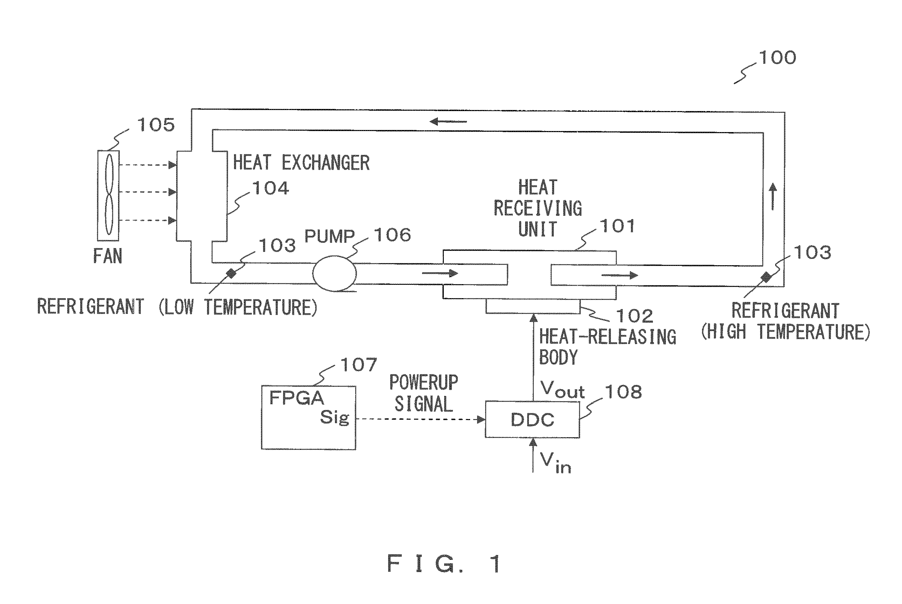

Meanwhile, a cooling system as illustrated in FIG. 1 is another example of a system for cooling a heat-releasing body with a liquid refrigerant.

A cooling system 100 illustrated in FIG. 1 includes a heat receiving unit 101 that cools a heat-releasing body 102 by transferring the heat of the heat-releasing body 102 to a refrigerant 103. The refrigerant 103, which has been heated due to absorption of the heat of the heat-releasing body 102, is cooled at a heat exchanger 104 by air sent from a fan 105. A pump 106 supplies water to circulate the refrigerant 103 in the cooling system 100.

Power supply to the heat-releasing body 102 is controlled by a powerup signal transmitted from an FPGA (Field-Programmable Gate Array) 107. The powerup signal transmitted from the FPGA 107 is input to a DDC (a digital-digital converting circuit) 108 that functions as a power supply circuit by supplying electricity to the heat-releasing body. According to the state of the received powerup signal, the DDC 108 converts an input voltage so as to supply electricity to the heat-releasing body.

The technology described in the following document is known.
Document 1: Japanese Laid-open Patent Publication No. 02-275 275

### SUMMARY

In one aspect, an object of the present invention is to prevent a heat-releasing body from being operated without a cooling unit being normally driven due to an unintentional powerup signal output to a power-supply circuit of the heat-releasing body.

According to an aspect of the embodiment, A power-supply controlling system includes an integrated circuit, a detecting unit, a state signal generating unit, and an output unit. The integrated circuit outputs a first instruction signal, which instructs an electricity-supply unit to supply electricity to a device that releases heat. The detecting unit detects an operating status of a cooling unit that cools the device. The state signal generating unit generates a state signal in accordance with the detected operating status, the state signal indicating whether or not the cooling unit is being driven. The output unit generates a second instruction signal by using the first instruction signal and the state signal, and outputs the second instruction signal to the electricity-supply unit, the second instruction signal giving an instruction to supply electricity to the device.

### BRIEF DESCRIPTION OF DRAWINGS

FIG. 1 illustrates an exemplary configuration of a cooling system.
FIG. 2 illustrates an exemplary signal waveform indicated when an unintentional powerup signal is output.
FIG. 3 is an example of a functional block diagram of a power-supply controlling system in accordance with the embodiment.
FIG. 4 illustrates an exemplary configuration of a power-supply controlling system in accordance with the embodiment.
FIG. 5 illustrates an operation to prevent an unintentional powerup signal from being output to a power-supply circuit.
FIG. 6 illustrates an exemplary configuration of a power-supply controlling system that generates a control signal according to a drive state of a cooling unit.

### DESCRIPTION OF EMBODIMENTS

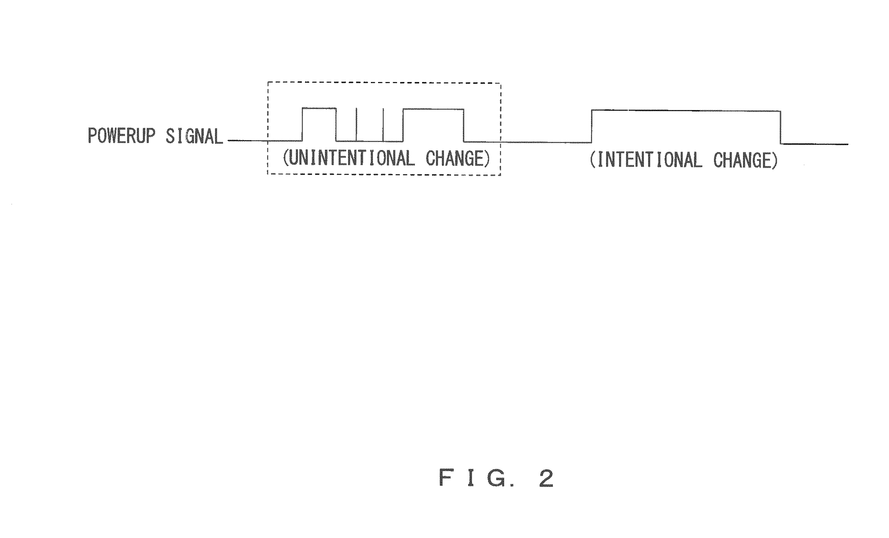

In the cooling system 100, ON/OFF of the DDC for power supply to the heat-releasing body is controlled by an output signal of an integrated circuit such as an FPGA. Integrated circuits have been progressively more highly integrated and pins thereon have been progressively more narrowly pitched. Accordingly, due to, for example, interference between adjacent wires on an integrated circuit or a short circuit between pins caused by conductive dust, an unintentional powerup signal as illustrated in FIG. 2 is sometimes output.

Specific examples of a situation in which such an unintentional powerup occurs include a case in which an unintentional signal is output at the time of initializing a highly integrated element or at the time of using a special function and, as a result, a powerup signal is put in an ON-state. The time of initializing a highly integrated element is, for example, the time of a Configuration operation. The time of using a special function is, for example, the time of a JTAG (Joint Test Action Group) debug operation.

In relation to narrow intervals between terminals due to a fine package of a highly integrated element, in some cases, adhesion of minute conductive dust puts an output element in an unintentional state, thereby putting a powerup signal in an ON-state.

The unintentional powerup signal that is issued in a case as described above may possibly be issued while a cooling system is being stopped. In this case, a heat-releasing body is operated while the cooling system is being stopped, thereby causing local boiling in a refrigerant, with the result that the cooling system and the heat-releasing body are damaged.

For the aforementioned fluid-temperature controlling system, behaviors of the FPGA and the power-supply circuit are not considered, so this system cannot be adapted to a situation in which an unintentional powerup signal is issued from the FPGA to the power-supply circuit.

The information processing apparatus in accordance with the present embodiment may prevent a heat-releasing body from being operated without a cooling unit being normally driven due to an unintentional powerup signal output to a power-supply circuit.

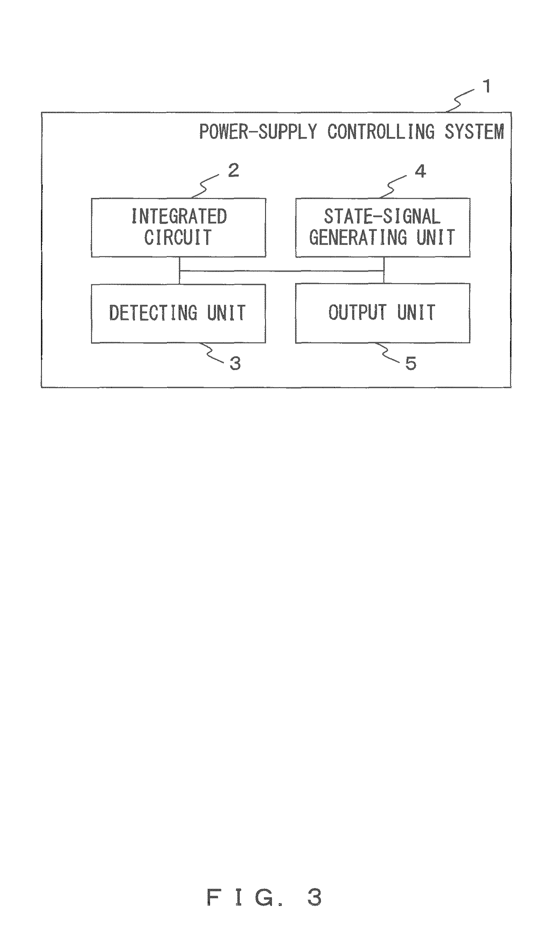

FIG. 3 is an example of a functional block diagram of a power-supply controlling system in accordance with the embodiment. A power-supply controlling system 1 includes an integrated circuit 2, a detecting unit 3, a state-signal generating unit 4, and an output unit 5.

The integrated circuit 2 outputs a first instruction signal, which instructs an electricity-supply unit to supply electricity to a device that releases heat.

The detecting unit 3 detects an operating status of a cooling unit that cools the device. The detecting unit 3 also detects, for the cooling unit, the flow rate of a fluid, the pressure on a duct, the rotational speed of a pump, or the rotational speed of a fan, the cooling unit including: a duct that circulates fluid in the device; a pump that sends fluid; and a fan that air-cools fluid.

In accordance with the detected operating status, the state-signal generating unit 4 generates a state signal that indicates whether or not the cooling unit is being driven.

Using the first instruction signal and the state signal, the output unit 5 generates a second instruction signal that gives an instruction to supply electricity to the device, and the output unit 5 outputs the second instruction signal to an electricity supplying unit. When the state signal indicates that the cooling unit is being driven, the output unit 5 uses the first instruction signal and the state signal so as to generate and output, to the electricity supplying unit, the second instruction signal that gives an instruction to supply electricity to the device.

Such a configuration allows an unintentional powerup signal that would be issued to the power supply circuit to be prevented from being input to the power supply circuit, so that the cooling unit and the device that releases heat can be prevented from being damaged due to an unexpected powerup.

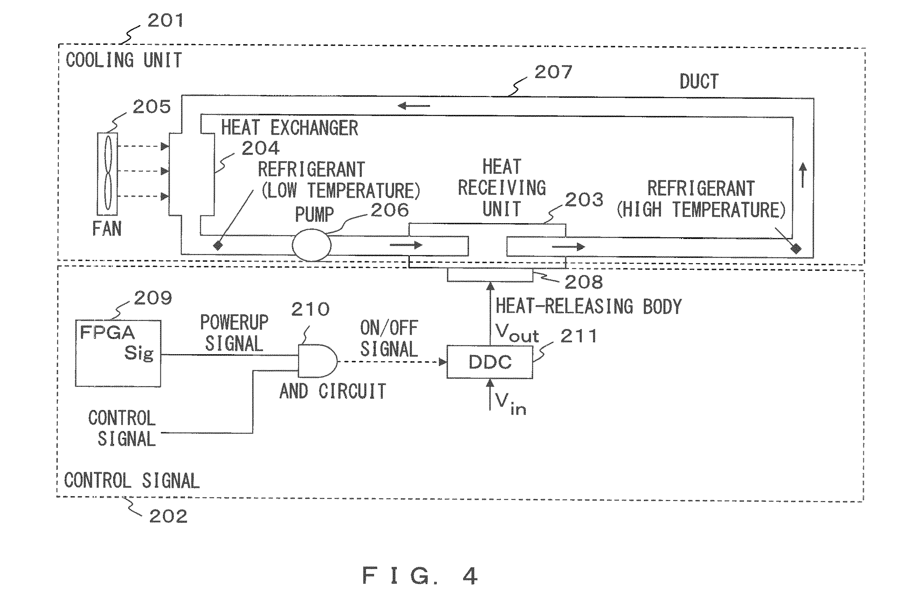

FIG. 4 illustrates a configuration of a power-supply controlling system in accordance with the embodiment. The power-supply controlling system 1 includes a cooling unit 201 that cools a heat-releasing body, and a controlling unit 202 that controls power supply to the heat-releasing body.

The cooling unit 201 includes a heat receiving unit 203, a heat exchanger 204, a fan 205, a pump 206, and a duct 207. The heat receiving unit 203 transfers the heat of the heat-releasing body to a refrigerant via, for example, a heat conductor, thereby cooling the heat-releasing body. Using air sent from the fan 205, the heat exchanger 204 cools the refrigerant, which has been heated due to absorption of the heat of the heat-releasing body at the heat receiving unit 203. The fan 205 cools the refrigerant by sending air to the heat exchanger 204. The pump 206 supplies water to circulate the refrigerant in the duct 207. The refrigerant is circulated in the duct 207, which connects the heat receiving unit 203, the heat exchanger 204, and the pump 206.

The controlling unit 202 includes a heat-releasing body 208, an FPGA 209, an AND circuit 210, and a DDC 211. The FPGA 209 is an example of the integrated circuit 2. The AND circuit 210 is an example of the output unit 5. The DDC 211 is an example of the electricity-supply unit.

The heat-releasing body 208 is driven via electricity being supplied from the DDC 211 and is heated responsively. The heat receiving unit 203 of the cooling unit 201 cools the heat-releasing body 208 by transferring the heat of the heat-releasing body 208 to the refrigerant. The heat-releasing body 208 is, for example, a CPU (Central Processing Unit).

The FPGA 209 transmits to the AND circuit 210 a powerup signal for the heat-releasing body 208.

The AND circuit 210 receives a control signal to prevent an unintentional powerup signal from being input to the DDC 211 and a powerup signal transmitted from the FPGA 209 and, according to the two received signals, outputs an ON/OFF signal to the DDC 211. That is, when the received control signal is in an ON state and the received powerup signal is in the ON state, the AND circuit 210 puts the ON/OFF signal in the ON state and then outputs this ON/OFF signal. When the control signal is in an OFF state, the AND circuit 210 puts the ON/OFF signal in the OFF state and then outputs this ON/OFF signal, whether the powerup signal is in the ON state or the OFF state. In particular, the AND circuit 210 receives the control signal and the powerup signal transmitted from the FPGA 209, calculates the logical product of the received two signals, and outputs the resultant product to the DDC 211 as an ON/OFF signal.

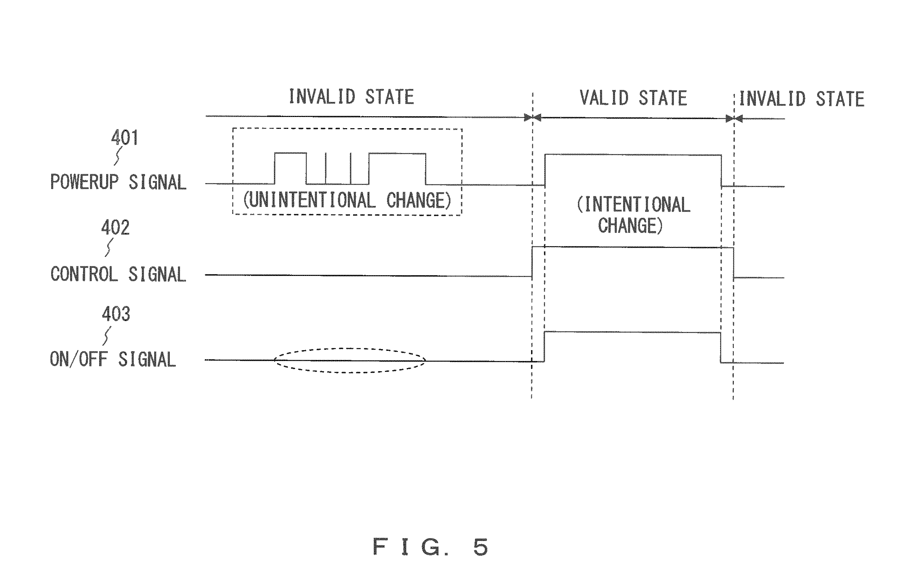

The control signal received by the AND circuit 210 is used to prevent an unintentional powerup signal from being output to DDC 211. FIG. 5 illustrates the preventing of an unintentional powerup signal from being output to a DDC by using an AND circuit. A symbol 401 illustrates a powerup signal from the FPGA 209. A symbol 402 illustrates a control signal. A symbol 403 illustrates an ON/OFF signal output to DDC 211. The ON/OFF signal 403 is a logical product of the powerup signal 401 and the control signal 402. Accordingly, as long as the control signal is in the OFF state, the ON/OFF signal output to the DDC 211 is put in the OFF state even if the powerup signal is unintentionally operated, thereby allowing the heat-releasing body 208 to be prevented from being unintentionally powered up. To power up the heat-releasing body 208, the control signal is put in the ON state and the powerup signal is then issued from the FPGA 209. When the power does not need to be turned on, the control signal is put in the OFF state.

The DDC 211 functions as a power supply circuit for the heat-releasing body 208. To supply electricity to the heat-releasing body 208, the DDC 211 converts an input voltage into a suitable voltage to be input to the heat-releasing body 208. The DDC 211 receives an ON/OFF signal from the AND circuit 210 and supplies electricity to the heat-releasing body 208 according to the value of the received ON/OFF signal. For example, when the received ON/OFF signal is in the ON state (e.g., a high level), the DDC 211 supplies electricity to drive the heat-releasing body 208; when the value of the ON/OFF signal indicates the OFF state (e.g., a low level), the DDC 211 does not supply electricity to the heat-releasing body 208.

The FPGA 209 may be an integrated circuit, e.g., an ASIC (Application Specific Integrated Circuit). The DDC 211 may be a power supply circuit that functions as a circuit to supply electricity to the heat-releasing body 208.

A powerup signal for the heat-releasing body 208 that is unintentionally issued while the cooling unit 201 is not being driven may possibly cause the cooling unit 201 and the heat-releasing body 208 to be damaged. Accordingly, to prevent such damage, the control signal that controls ON/OFF is controlled in accordance with whether or not the cooling unit 201 is being normally driven. That is, the control signal is put in the ON state while the cooling unit 201 is being normally driven and is put in the OFF state while the cooling unit 201 is not being normally driven. A determination of whether or not the cooling unit 201 is being normally driven is made according to, for example, the rotational speed of the fan 205 and the rotational speed of the pump 206.

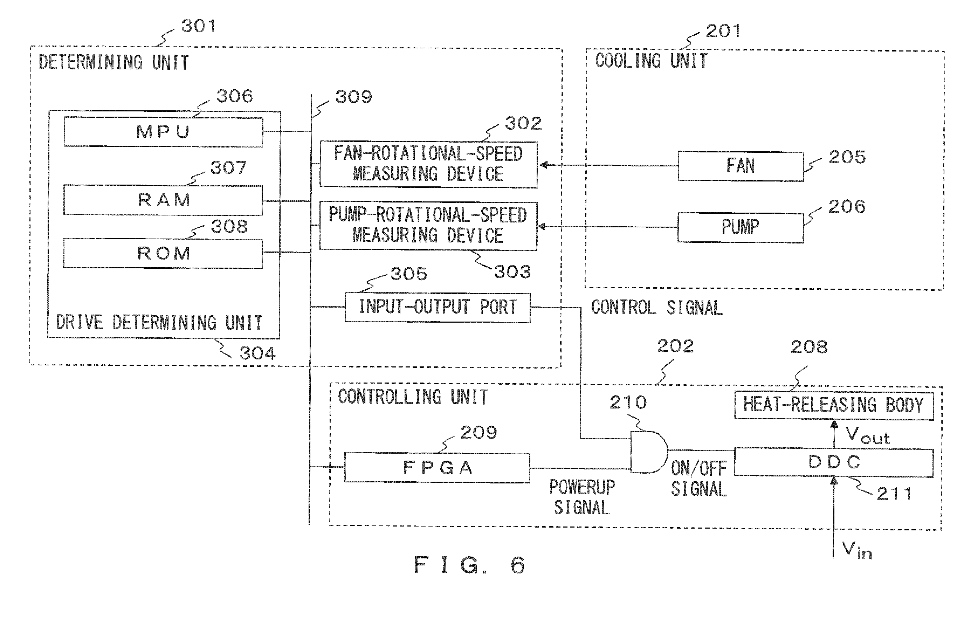

FIG. 6 is a configuration diagram of a power-supply controlling system that generates a control signal according to a drive state of a cooling unit. A power-supply controlling system 1 includes a cooling unit 201, a controlling unit 202, and a determining unit 301. The configuration of the cooling unit 201 and the controlling unit 202 are the same as that described with reference to FIG. 4.

The determining unit 301 includes a fan-rotational-speed measuring device 302, a pump-rotational-speed measuring device 303, a drive determining unit 304, and an input-output port 305. The fan-rotational-speed measuring device 302 and the pump-rotational-speed measuring device 303 are examples of the detecting unit 3. The drive determining unit 304 is an example of the state-signal generating unit 4.

The drive determining unit 304 includes: an MPU (Micro-Processing Unit) 306 that is in charge of monitoring hardware; a RAM (Random Access Memory) 307; and a ROM (Read Only Memory) 308. A function of the drive determining unit 304 may be provided by, for example, a service processor or a microcontroller (an MCU). The MPU 306, the RAM 307, the ROM 308, the fan-rotational-speed measuring device 302, the pump-rotational-speed measuring device 303, and the FPGA 209 of the controlling unit 202 are connected via a bus 309.

The fan-rotational-speed measuring device 302 measures the number of rotations made per unit time by the fan 205 of the cooling unit 201 and outputs the result of measurement to the drive determining unit 304. The pump-rotational-speed measuring device 303 measures the number of rotations made per unit time by the pump 206 of the cooling unit 201 and outputs the result of measurement to the drive determining unit 304. The drive determining unit 304 receives information of the rotational speed of the fan 205 from the fan-rotational-speed measuring device 302 and information of the rotational speed of the pump 206 from the pump-rotational-speed measuring device 303, and determines a driving status of the cooling unit 201 using the received information. The drive determining unit 304 switches the ON/OFF state of a control signal in accordance with the result of determining the driving status and transmits the control signal to the AND circuit 210 via the input-output port 305.

The fan-rotational-speed measuring device 302 and the pump-rotational-speed measuring device 303 respectively measure the rotational speed of the fan 205 and the pump 206 by, for example, using square waves that are output using a magnet and a Hall element to detect the strength of magnetism that depends on rotation. A method for measuring the rotational speed of the fan 205 and the pump 206 may be achieved by providing a light slit.

Next, descriptions will be given of a specific operation performed by the drive determining unit 304 to determine a driving status of the cooling unit 201. The drive determining unit 304 determines whether or not the rotational speed of the fan 205 is equal to or greater than a predetermined threshold, and, when the result of determining indicates a value that is equal to or greater than the threshold, the drive determining unit 304 determines that the fan 205 is being normally driven. Next, the drive determining unit 304 determines whether or not the rotational speed of the pump 206 is equal to or greater than a predetermined threshold, and, when the result of determining indicates a value that is equal to or greater than the threshold, the drive determining unit 304 determines that the pump 206 is being normally driven. Subsequently, when the drive determining unit 304 determines that both the fan 205 and the pump 206 are being normally driven, the drive determining unit 304 determines that the cooling unit 201 is being normally driven; when the drive determining unit 304 determines that any of the fan 205 and the pump 206 are not being normally driven, the drive determining unit 304 determines that the cooling unit 201 is not being normally driven.

The drive determining unit 304 determines whether or not the cooling unit 201 is being normally driven using, for example, the aforementioned procedure, and then, in accordance with a result of the determining, outputs a control signal to the AND circuit 210. That is, when the drive determining unit 304 determines that the cooling unit 201 is being normally driven, the drive determining unit 304 outputs a control signal that indicates the ON state; when the drive determining unit 304 determines that the cooling unit 201 is not being normally driven, the drive determining unit 304 outputs a control signal that indicates the OFF state. The control signal is transmitted from the drive determining unit 304 via the input-output port 305 to the AND circuit 210.

The aforementioned operation to determine the driving status of the cooling unit 201 is repeated at predetermined time intervals, and, when the result of a determination made by the drive determining unit 304 as to the operating status of the cooling unit 201 changes, the value of a control signal output to the AND circuit 210 changes.

When a powerup signal that is in the ON state is output from the FPGA 209 while a control signal obtained from the drive determining unit 304 is indicating the ON state, the AND circuit 210 outputs an ON signal to DDC 211. When a powerup signal is output from the FPGA 209 while a control signal obtained from the drive determining unit 304 is indicating the OFF state, the AND circuit 210 outputs an OFF signal to the DDC 211.

The aforementioned determination on the driving status of the cooling unit 201 made by the drive determining unit 304 and the operation to output a control signal may be achieved via the MPU 306 reading an information processing program stored in the ROM 308 and loading this program into the RAM 307 so as to execute it. Information such as a threshold used in this process may be stored in the ROM 308 so that the MPU 306 can read and load this information into the RAM 307. Some of or all of these functions may be achieved with hardware.

A determination as to whether or not the cooling unit 201 is being normally driven may be made according to the value of a flow sensor that measures the flow rate of a refrigerant, the difference between the values of respective heat sensors located at the inlet and the outlet of the heat exchanger 204, or the value of a pressure sensor provided at the duct 207. Meanwhile, to stop the operation of the heat-releasing body 208, the signal from the FPGA 209 is put in the OFF state, and the control signal is then put in the OFF state.

The present embodiment is not limited to those described above. Without departing from the spirit of the present embodiment, various configurations or embodiments may be achieved.

The information processing apparatus in accordance with the present embodiment may prevent a heat-releasing body from being operated without a cooling unit being normally driven due to an unintentional powerup signal output to a power-supply circuit.

## Claims

1. A power-supply controlling system (1) comprising:
an integrated circuit (2) that outputs a first instruction signal, which instructs an electricity-supply unit to supply electricity to a device that releases heat;
a detecting unit (3) that detects an operating status of a cooling unit that cools the device;
a state signal generating unit (4) that generates a state signal in accordance with the detected operating status, the state signal indicating whether or not the cooling unit is being driven; and
an output unit (5) that generates a second instruction signal by using the first instruction signal and the state signal, and outputs the second instruction signal to the electricity-supply unit, the second instruction signal giving an instruction to supply electricity to the device.

2. The power-supply controlling system (1) according to claim 1, wherein
when the state signal indicates that the cooling unit is being driven, the output unit (5) uses the first instruction signal and the state signal so as to generate and output, to the electricity-supply unit, the second instruction signal that gives an instruction to supply electricity to the device.

3. The power-supply controlling system (1) according to claim 1, wherein
the cooling unit includes a duct that circulates fluid in the device, a pump that sends the fluid, and a fan that air-cools the fluid, and
the detecting unit (3) detects a flow rate of the fluid, a pressure on the duct, a rotational speed of the pump, or a rotational speed of the fan.

4. A power-supply controlling method comprising:
outputting, by an integrated circuit (2), a first instruction signal, which instructs an electricity-supply unit to supply electricity to a device that releases heat;
detecting, by a detecting unit (3), an operating status of a cooling unit that cools the device;
generating, by a state signal generating unit (4), a state signal in accordance with the detected operating status, the state signal indicating whether or not the cooling unit is being driven; and
generating, by an output unit (5), a second instruction signal by using the first instruction signal and the state signal, and outputting, by the output unit (5), the second instruction signal to the electricity-supply unit, the second instruction signal giving an instruction to supply electricity to the device.
